(19) Europäisches Patentamt
European Patent Office
Office européen des brevets

(11) **EP 1 883 162 A1**

(12) **EUROPEAN PATENT APPLICATION**

(43) Date of publication:
**30.01.2008 Bulletin 2008/05**

(51) Int Cl.:
**H03M 13/29** *(2006.01)*

(21) Application number: **06015514.0**

(22) Date of filing: **25.07.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Infineon Technologies AG**
**81669 München (DE)**

(72) Inventor: **Berkmann, Jens**
**81375 München (DE)**

(74) Representative: **Patentanwälte Lambsdorff & Lange**
**Dingolfinger Strasse 6**
**81673 München (DE)**

(54) **Non-periodic puncturing of turbo codes and convolutional codes**

(57) The code rate of a convolutional code or a turbo code is adjusted by means of puncturing patterns that jitter in the sense that the distances between bits to be punctured within the puncturing pattern or within consecutive puncturing patterns vary. This procedure breaks up the periodicity of the puncturing pattern and it is avoided that the infinite impulse response IIR property of a recursive systematic convolutional code is destroyed.

FIG 3

Printed by Jouve, 75001 PARIS (FR)

**Description**

The invention generally relates to puncturing a convolutional encoded signal, and in particular to puncturing a turbo encoded signal.

Convolutional codes are used in digital communication systems to protect transmitted information from error. Convolutional coding adds redundancy to a data signal to be transmitted. At a receiver, this redundancy is exploited for enhancing the reliability of the decoded data signal.

Turbo coding uses a parallel concatenated convolutional code. Turbo coding typically provides high error correction performance and is therefore used in a number of advanced communication systems including, in particular, mobile communication systems.

In order to generate convolutional error correcting codes of a certain data rate, rate matching is applied. Rate matching often comprises the method of puncturing. Puncturing means to not transmit (i.e. to "throw away") a certain amount of encoded bits of the so-called "mother code" generated by the encoder. The bits to be punctured are typically determined by a puncturing pattern. By varying the amount of bits to be punctured in the puncturing pattern, the resulting code rate can be arbitrarily adapted between the mother code's rate and 1.

Typically, a puncturing pattern has regular distances between bits to be punctured. The choice of the puncturing pattern has an impact on the error correction performance. More specifically, one particular puncturing pattern for obtaining a certain code rate could result in better error correction performance than another puncturing pattern generating the same code rate.

Hence, what may be desired is an improved puncturing pattern providing for superior error correction performance at a desired code rate.

According to a first aspect to the invention, there is provided a method for puncturing a turbo encoded signal comprising systematic bits and parity bits, the method comprising puncturing (at least) the parity bits, wherein the puncturing pattern used to adjust a desired code rate jitters. Herein, jittering of a puncturing pattern means that the distances between bits to be punctured within the puncturing pattern or within consecutive puncturing patterns vary more than 1. Applying a varying puncturing pattern may considerably improve the error correction performance of the resulting convolutional code.

It is to be noted that additional to puncturing parity bits, also systematic bits may be punctured.

According to a second aspect of the invention, there is provided a method for puncturing a turbo encoded signal comprising systematic bits, first parity bits and second parity bits, the method comprising puncturing the first parity bits using a first puncturing pattern and puncturing the second parity bits using a second puncturing pattern. The first puncturing pattern is different from the second puncturing pattern for an even total number of first and second parity bits to be punctured. Or, for an odd total number of bits to be punctured, the number of bits to be punctured in the first puncturing pattern is different from the number of bits to be punctured in the second puncturing pattern by 2 or more. By applying different puncturing patterns to the stream of first parity bits and the stream of second parity bits, the error correction performance of the resulting code may enhance.

Further, according to still another aspect of the invention, there is provided a method for puncturing a convolutional encoded signal comprising a stream of encoded bits, wherein the puncturing pattern used to adjust a desired code rate jitters. Again, as a jittering puncturing pattern is applied, the error correction performance of the resulting code may improve.

Aspects of the invention are made more evident in the following detailed description of some embodiments, when read in conjunction with the attached drawing figures, wherein:

Fig. 1    is a block diagram illustrating code generation by channel coding and rate matching;

Fig. 2    is a schematic diagram showing a turbo coder;

Fig. 3    is a block diagram illustrating rate matching for turbo codes; and

Fig. 4    is a block diagram illustrating another example for rate matching for turbo codes.

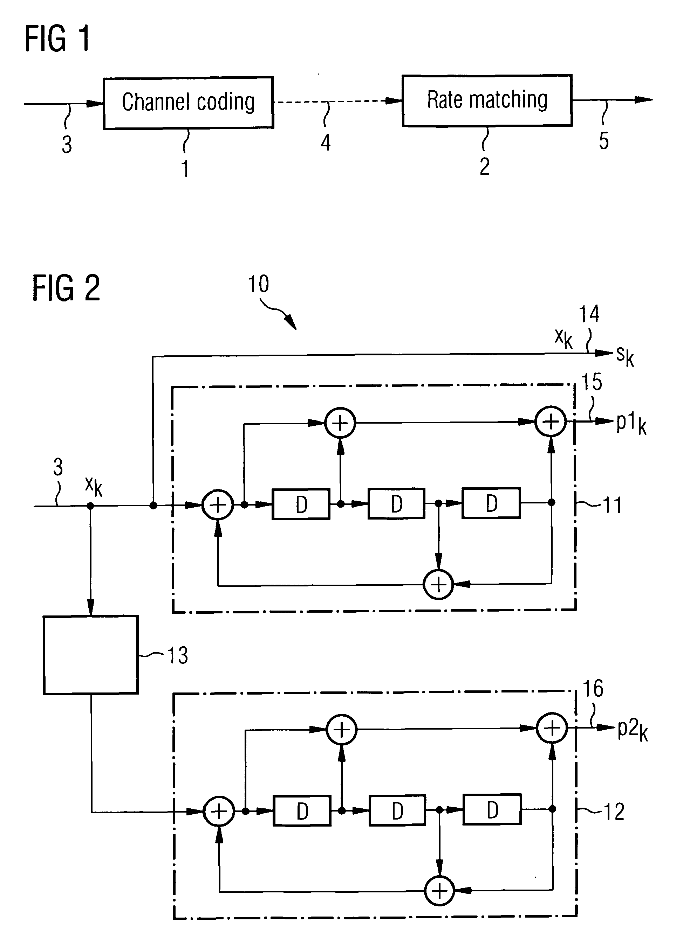

According to Fig. 1, an error correction code is generated by channel coding and rate matching. The channel encoder 1 performs convolutional encoding on an input date stream 3. The channel encoder 1 outputs a so-called mother code at its output 4. This mother code, after optional further data processing, is input to a rate matching device 2. The rate matching device 2 punctures the input mother code by repeatedly applying a puncturing pattern on predefined intervals of the input mother code. By varying the amount of punctured bits in the puncturing pattern, the code rate of the resulting code provided at the output 5 of the rate matching device 2 can be set to a desired code rate between the mother code's rate and 1. The code rate is the ratio of the number of information bits to the total number of encoded bits. In the following, the code rate at output 4 (i.e. before rate matching) will be denoted as mother code's rate and the code rate at output 5 (i.e. after rate matching) will be denoted as resulting code rate or briefly code rate.

For a given mother code's rate at the output 4 of the channel encoder 1, a desired code rate at the output 5 of the rate matching device 2 may be achieved by varying the amount of punctured bits per interval, i.e. per puncturing pattern. Different puncturing patterns provide for the same resulting code rate at the output 5 if the number of bits to be punctured in the different puncturing patterns is the same.

Fig. 2 depicts an exemplary schematic of a turbo coder 10. Such turbo coder 10 may be used as the channel encoder 1 shown in Fig. 1. The turbo coder 10 comprises a first constituent encoder 11, a second constituent encoder 12 and a block interleaver 13. The input of the first constituent encoder 11 is connected to the turbo coder input 3. The input of the second constituent encoder 12 is coupled via the block interleaver 13 to the turbo coder input 3. The turbo coder 10 has three outputs 14, 15, 16. The output 14 provides the so-called systematic signal s. The output 15 from the first constituent encoder 11 is the first parity signal p1 and the output 16 from the second constituent encoder 12 is the second parity signal p2.

The input data sequence at input 3 is denoted by $x_k$, wherein k is the discrete time index of bits $x_k$. Systematic bits $S_k$ at output 14 are the unprocessed input bits $x_k$. First parity bits at output 15 are denoted by $p1_k$ and second parity bits at output 16 are denoted by $p2_k$. Thus, output from the turbo coder 10 is $s_1, p1_1, p2_1, S_2, p1_2, p2_2$...

As three output bits $s_k, p1_k, p2_k$ are generated for each input bit $x_k$, the code rate of the mother code generated by the turbo coder 10 depicted in Fig. 2 is 1/3.

Each constituent encoder 11, 12 may comprise a shift register with three delay elements D, i.e. is a 8-state convolutional encoder. The underlying systematic recursive convolutional code of each constituent encoder 11, 12 is of code rate 1/2 and described by the transfer function

$$G(D) = \left[1, \frac{g_1(D)}{g_0(D)}\right],$$

where

$$g_0(D) = 1 + D^2 + D^3,$$

$$g_1(D) = 1 + D + D^3.$$

The turbo coder 10 depicted in Fig. 2 is stipulated in the UMTS-Standard 3GPP TS 25.212 V7.1.0 (2006-06). However, it should be understood that turbo coders of different design and transfer function may be embodiments of the invention. In particular, turbo coders employing two systematic recursive rate 1/3 convolutional constituent encoders are possible. Such turbo coders output 4 parity bit streams, and each of these 4 output parity bit streams may have infinite impulse response. Although the following examples address to turbo coders generating 2 parity bit streams, the invention is not confined to such specific implementation.

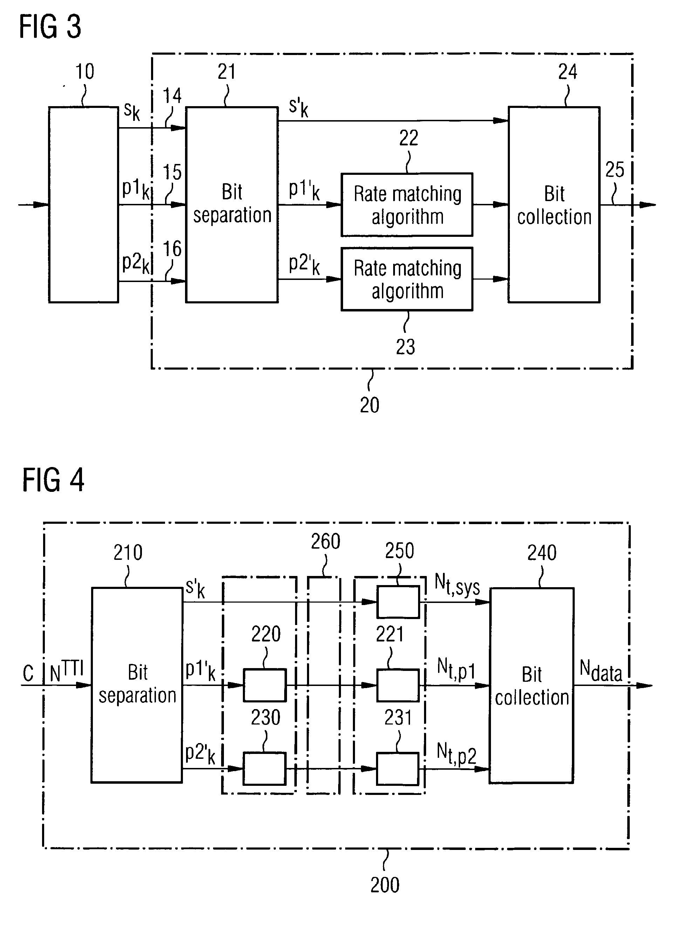

Fig. 3 illustrates a block diagram depicting channel coding and rate matching. As an example, the turbo coder 10 may be used for channel coding. A rate matching device 20 comprises an optional bit separation stage 21, a first rate matching stage 22, a second rate matching stage 23 and an optional bit collection stage 24.

The bit separation stage 21 receives the systematic bits $s_k$, the first parity bits $p1_k$ and the second parity bits $p2_k$. The systematic bits $s_k$ from the turbo coder 10 shall not be punctured, whereas the parity bits $p1_k, p2_k$ may be punctured. The systematic bits $s_k$, the first parity bits $p1_k$ and the second parity bits $p2_k$ input to the rate matching device 20 are separated into three sequences $s_k, p1'_k, p2'_k$. The first sequence $s'_k$ contains all of the systematic bits $s_k$ from the turbo coder 10. Further, from 0 to 2 first and/or second parity bits $p1_k$ and $p2_k$ may be added.

The second sequence $p1'_k$ contains all first parity bits $p1_k$ except those that go into the first sequence $s_k$, if any.

The third sequence $p2'_k$ contains all second parity bits $p2_k$ except those that go into the first sequence $s'_k$, if any.

The second sequence $p1'_k$ containing only first parity bits $p1_k$ is processed by the first rate matching (i.e. puncturing) stage 22 and the third sequence $p2'_k$ containing only second parity bits $p2_k$ is processed by the second rate matching (i.e. puncturing) stage 23.

The outputs of the rate matching stages 22 and 23 are connected to the bit collection stage 24. The bit collection stage 24 provides at its output 25 a single bit stream generated from these three input bit streams.

Fig. 3 corresponds to the rate matching scheme used in the standard 3GPP TS 25.212 V7.1.0 (2006-06). It should be understood that other designs of a rate matching device 20 could be used. In particular, data processing different from the bit separation stage 21 used between the turbo coder 10 and the rate matching stages 22, 23 may be implemented.

Using the notation of the aforementioned 3GPP-Standard, the number of bits in a transmission time interval (TTI) before rate matching on the transport channel (TrCH) with index i with transport format 1 is denoted by $N_{i,1}^{TTI}$.

The total number of parity bits to be punctured in each TTI on TrCH i with transport format 1 is denoted by $\Delta N_{i,1}^{TTI}$. The aforementioned 3GPP-Standard divides the amount of puncturing equally on the two parity bit streams $p1_k$ and $p2_k$, i.e. floor $\left(\Delta N_{i,1}^{TTI} / 2\right)$ first parity bits $p1'_k$ are punctured and ceil $\texttt{ceil}\left(\Delta N_{i,1}^{TTI} / 2\right)$ second parity bits $p2'_k$ are punctured. Thus, the number of bits to be punctured in the rate matching stages 22, 23 has a maximum difference of 1 over a TTI.

Further, the puncturing pattern algorithm described in Section 4.2.7.5 of the aforementioned 3GPP-Standard is most regular in the sense that the distance between bits to be punctured is almost constant. More precisely, the distance between punctured bits is either some integer d or d+1.

According to a first embodiment of the present invention, a non-equal puncturing rate is applied to the outputs 15, 16 of each of the constituent encoders 11, 12. In other words, the rate matching stages 22, 23 operate with different puncturing rates. As an example, in the case of an even number $\Delta N_{i,1}^{TTI}$ of parity bits to be punctured, the number of first parity bits punctured in the rate matching stage 22 may be different to the number of second parity bits punctured in the rate matching stage 23. Further, in the case of an odd number $\Delta N_{i,1}^{TTI}$ of parity bits to be punctured, the difference between the number of first parity bits punctured in the first rate matching stage 22 and the number of second parity bits in the second rate matching stage 23 may be larger than 1.

More specifically, the rate matching stage 22 may puncture floor($\Delta N^{TTI}/2$)+k first parity bits and the rate matching stage 23 may puncture ceil($\Delta N^{TTI}/2$)-k second parity bits for some integer k different from 0. This provides for a more general and unequal puncturing of the first parity bits $p1_k$ or $p1'_k$ and second parity bits $p2_k$ or $p2'_k$ compared to the conventional puncturing scheme. Further, it is also possible that the rate matching stage 22 may puncture floor($\Delta N^{TTI}/2$)-k first parity bits and the rate matching stage 23 may puncture ceil($\Delta N^{TTI}/2$)+k second parity bits.

Fig. 4 shows a block diagram depicting channel coding and rate matching used for HSDPA (High Speed Downlink Packet Access) as stipulated in 3GPP TS 25.212 V7.1.0 (2006-06), Section 4.5.4. Comparable to Fig. 3, a rate matching device 200 comprises an optional bit separation stage 210, a first rate matching stage 220, a second rate matching stage 230 and an optional bit collection stage 240. The function of these devices are similar to the function of the devices 21, 22, 23, 24 shown in Fig. 3. In particular, the puncturing in rate matching stages 220 and 230 is the same as in the rate matching stages 22 and 23 used for non-HSDPA channels. In addition, the HSDPA rate matching device 200 comprises further rate matching stages 221, 231 and 250 and a buffer 260. The rate matching stages 221 and 231 process first and second parity bits output from the rate matching stages 220 and 230, respectively. The rate matching stage 250 processes systematic bits to provide for the HARQ (Hybrid Automatic Request) functionality implemented in HSDPA. As is fully described in 3GPP TS 25.212 V7.1.0 (2006-06), Section 4.2.7.5, the basic puncturing pattern determination algorithm is the same in all rate matching stages 22, 23, 220, 230, 221, 231, 250 and for all bit types (first parity bits, second parity bits, systematic bits).

To adhere to the notation in the 3GPP Standard, here $N_{data}$ is the number of bits in one TTI and $N_{sys}$ is the number of systematic bits before rate matching in stage 250. $N_{t,sys}$ is the number of transmitted systematic bits (i.e. after rate matching) in one TTI and $N_{t,p1}$, $N_{t,p2}$ are the numbers of transmitted first and transmitted second parity bits in one TTI, respectively. The 3GPP Standard requires
$N_{t,sys}$ = floor($N_{sys} \cdot N_{data}/(N_{sys}+2N_{p1})$), $N_{t,p1}$ = floor ( $(N_{data}-N_{t,sys})$ /2) and $N_{t,p2}$ = ceil(($N_{data}-N_{t,sys}$)/2). For introduction of puncturing jitter, the rate matching stages 250, 221, 231 may puncture $N_{t,sys}$ floor($N_{sys} \cdot N_{data}/(N_{sys}+2N_{p1})$), $N_{t,p1}$ = floor(($N_{data}-N_{t,sys}$) /2) -k or $N_{t,p1}$ = floor( $(N_{data}-N_{t,sys})$ /2) +k and $N_{t,p2}$ = ceil ($N_{data}-N_{t,sys}$) /2) +k or $N_{t,p2}$ = ceil ( $(N_{data}-N_{t,sys})$ /2) -k, respectively.

It is to be noted that the scheme proposed according to the first embodiment (Fig. 3 and 4) of the invention may not effect the rate matching pattern applied in the rate matching stages 22, 23, 220, 230, 221, 231, 250 at all. It is only the parameterization (the input k to the rate matching pattern algorithm) which changes. Thus, the first embodiment of the invention may be used within the aforementioned 3GPP-Standard without modifying the puncturing pattern algorithm stipulated therein. In particular, the most regular puncturing pattern as stipulated in Section 4.2.7.5 of the aforementioned 3GPP-Standard may be used.

According to a second embodiment of the invention, the rate matching pattern algorithms applied in the rate matching stage 22 and the rate matching stage 23 are modified. In the second embodiment, the rate matching stages 22 and 23 may operate at equal puncturing rates. However, the regular rate matching algorithm as stipulated in the aforementioned 3GPP-Standard is modified in such a way that it produces a puncturing pattern that jitters. In a jittering puncturing pattern, the distance between punctured bits should be not just d and d+1 but also d+2 or even d+3 within the puncturing interval. Of course, further different distances d+4, d+5, ... are also possible.

As a first example for the second embodiment of the invention, a puncturing pattern is considered that punctures 6 out of 7 bits in a regular fashion. This regular puncturing mechanism can be described by the row vector (1000000) where 0 indicates to puncture the corresponding bit and 1 indicates to not puncture the corresponding bit. In this example, always only the first bit of a vector of 7 bits is transmitted (not punctured). In order to generate some "jitter", the puncturing vector can be enlarged to represent a vector of 14 bits out of which 12 bits are punctured. For instance, with the jittering puncturing vector (10000010000000), the distance between non-punctured bits is either 5 or 7 (i.e. two values different from each other by more than 1) and not always 6 like it where in the 3GPP-Standard regular puncturing case. Of course, larger periodicities of the puncturing vector can also be applied. The resulting code rate is not effected by the jitter introduced.

Further, it is apparent from the above that "jittering" of a puncturing pattern may either be understood as an "intrinsic" jitter showing up within a (single) puncturing pattern (10000010000000) or as an "extrinsic" jitter generated by the repetition of (two or more) different consecutive puncturing patterns (1000001)(0000000)(1000001)(0000000).... Both views are part of the invention.

As a second example for the second embodiment, the puncturing pattern determination algorithm according to the aforementioned 3GPP-Standard and a corresponding "jittering" variation of this puncturing pattern determination algorithm are considered:

The original 3GPP-Standard puncturing pattern determination algorithm reads as follows:

```
e = e_ini              -- initial error between current and
                          desired puncturing ratio

m = 1                  -- index of current bit
do while m <= X_i
    e = e - e_minus    -- update error



    if e <= 0 then     -- check if bit number m should be
                          punctured
        set bit x_i,m to δ where δ∉{0,1}
        e = e + e_plus   -- update error
    end if
    m = m + 1          -- next bit
end do
```

In this algorithm, $e_{ini}$ denotes an initial value of the variable e used in the puncturing pattern determination algorithm set out above. $X_i$ may be 1/3 of the number of bits in a TTI before rate matching on TrCH i, i.e. $X_i = N_{i,1}^{TTI}/3$ . For TrCHs in HSDPA, $X_i = N_{sys}$ for puncturing systematic bits in rate matching stage 250, $X_i = N_{p1}$ for puncturing first parity bits in rate matching stage 221 and $X_i = N_{p2}$ for puncturing second parity bits in rate matching stage 231 (see 3GPP TS 25.212 V7.1.0 (2006-06), Section 4.5.4.3) . $e_{minus}$ denotes the decrement of variable e in the puncturing pattern determination algorithm. $x_{i,m}$ is the bit with index m associated to TrCH i. $\delta$ is a marker indicating that the marked bit is to be punctured. $e_{plus}$ is the increment of variable e in the puncturing pattern determination algorithm.

According to the invention, a possible jittering puncturing pattern determination algorithm may be formulated as follows:

```
e = e_ini            -- initial error between current and
                        desired puncturing ratio
k = 1
m = 1                -- index of current bit
do while m <= X_i
    e = e - e_minus(k)   -- update error
    if e <= 0 then       -- check if bit number m should be
                            punctured
        set bit x_i,m to δ where δ∉{0,1}
        e = e + e_plus(k) -- update error
    else



        k = (k+1)mod2
    end if
    m = m + 1                -- next bit
end do
```

By comparing the 3GPP-Standard puncturing pattern determination algorithm and the jittering puncturing pattern determination algorithm, the jitter in the latter algorithm is implemented by the expression k = (k+1)mod2 and the dependency of $e_{minus}(k)$ and $e_{plus}(k)$ from k. In this example, k toggles between 0 and 1. Choosing two different values for $e_{minus}(0)$ and $e_{minus}(1)$ and choosing two different values $e_{plus}(0)$, $e_{plus}(1)$, respectively, produces a jittering rate matching (i.e. puncturing) pattern in accordance with the invention.

The jitter-generating expression k = (k+1)mod2 in the above exemplary jittering puncturing pattern determination algorithm may be generalized to k = (k+1)mod n, with n being an integer greater than 2. Then, k toggles between 0 and n-1 and different values for $e_{minus}(0)$, $e_{minus}(1)$, ..., $e_{minus}(n-1)$ as well as different values $e_{plus}(0)$, $e_{plus}(1)$, ..., $e_{plus}(n-1)$ should be choosen, respectively,. Further, jitter-generating expression different to k = (k+1)mod n may be implemented.

Although the above jittering puncturing pattern determination algorithm relates to downlink turbo coding and rate matching according to the 3GPP-Standard, essentially the same algorithm may be used for uplink turbo coding and rate matching. Further, the above algorithm may also be applied to conventional convolutional codes (not turbo-codes).

In this case, $X_i = N_{i,1}^{TTI}$.

In turbo coders 10, the constituent encoders 11, 12 are typically IIR (infinite impulse response). Both embodiments of the invention are specifically effective in enhancing the forward error correction performance when they happen to avoid that the IIR-property of the code generated by the constituent encoders 11, 12 is destroyed by the puncturing performed in the rate matching device 20.

Referring, as an example, to the turbo coder 10, the infinite impulse response of the constituent encoders 11, 12 is represented by the sequence $1+D+D^2+D^3+D^6+D^8+D^9+D^{10}+D^{13}$..., which repeats every 7 time instants. For turbo coding, an infinite impulse response of the constituent encoders 11, 12 is important because only in this case, error correction performance of a turbo code improves with increasing block length (i.e. code length). However, for some resulting code rates at the output 25, the puncturing pattern applied according to the 3GPP-Standard destroys the infinite impulse response of the constituent encoders 11, 12. For instance, in order to arrive at a resulting code rate of 3/4 at output 25 after rate matching, the 3GPP-Standard employs puncturing both constituent encoders 11, 12 to a rate of 7/8 in the rate matching stages 22, 23, respectively. The constituent encoders 11, 12 effectively have a finite impulse response (FIR) after 3GPP-puncturing to a rate of 7/8. As the infinite impulse response property is a vital condition for turbo codes to process a so-called interleaver gain, exceptionally bad BLER (block error rate) performance is faced for constituent encoders 11, 12 being punctured to a code rate of 7/8. This is, inter alia, a sever limitation for HSDPA, where resulting code rates around 3/4 are typical operating points in conjunction with 16-QAM.

In general, the IIR-property of the constituent encoders 11, 12 is effectively destroyed in the 3GPP-Standard for constituent code rates of approximately $7n/(7n+1)$, n being any positive integer. Constituent code rates are code rates at the output of the rate matching stages 22, 23. At all these constituent code rates, no interleaver gain is experienced and thus, the BLER performance is exceptionally bad. As a consequence, when considering the required SNR (signal-to-noise-ratio) to achieve a certain BLER, there is no smooth and monotone dependency of the required SNR on the resulting code rate. From a system conception point of view, it is desired that the higher the resulting code rate the more SNR should be required. However, using for instance the 3GPP-Standard, for resulting codes generated by constituent codes punctured to rates of about $7n/(7n+1)$, abnormal higher SNR is required than for codes of higher resulting code rates. Thus, any performance degradation due to "bad" puncturing patterns will directly translate into system capacity losses and/or thoughput degradation observed by the user. In other words, the 3GPP-Standard disregards the influence of the puncturing pattern on the impulse response of the underlying recursive convolutional code used in the constituent encoders 11, 12.

Therefore, according to another aspect of the invention, the puncturing pattern is selected such that it avoids to destroy the IIR-property of the constituent code used in the constituent encoders 11, 12 of the turbo coder 10. Referring to the 3GPP-Standard such enhanced puncturing patterns have to be used for constituent code rates punctured to approximately $7n/(7n+1)$. The first embodiment of the invention (applying different puncturing rates in the rate matching stages 22, 23) and the second embodiment of the invention (applying time variant (i.e. jittering) puncturing patterns in the rate matching stages 23, 22) both maintain the IIR-property of the constituent code generated by the constituent encoders 11, 12 after puncturing to constituent code rates of $7n/(7n+1)$ at the outputs of the rate matching stages 22, 23.

Although the IIR-property of the constituent encoders is perfectly destroyed in the 3GPP-Standard for constituent code rates of exactly $7n/(7n+1)$, it is to be noted that the code performance already decreases when the code rate is only in the vicinity of $7n/(7n+1)$ owing to the fact that the IIR-property is already impaired in the vicinity of $7n/(7n+1)$. Therefore, jittering puncturing patterns should be applied also in the case of constituent code rates in the vicinity of $7n/(7n+1)$.

The invention is especially effective for turbo codes and may be used in all communication systems processing turbo codes, e.g. HSDPA. Further, as already mentioned, the second embodiment (using jittering puncturing patterns) may also be applied to conventional convolutional codes (not turbo-codes) as illustrated in Fig. 1. Also in this case, the forward error correction performance may benefit from the time variance of the applied jittering puncturing pattern.

**Claims**

1.    A method for puncturing a turbo encoded signal containing systematic bits and parity bits, comprising puncturing the parity bits according to a puncturing pattern to adjust a desired code rate, wherein the puncturing pattern jitters.

2.    The method according to claim 1, wherein
the parity bits comprise first and second parity bits,
the first parity bits are punctured using a first jittering puncturing pattern, and
the second parity bits are punctured using a second jittering puncturing pattern.

3.    The method according to claim 2, wherein
the first puncturing pattern and the second puncturing pattern are the same.

4.    The method according to one of the preceding claims,
wherein a puncturing pattern is defined by a function defining the distance between parity bits to be punctured, the function having at least two different function values being different to each other by more than 1.

5.    The method according to one of the preceding claims,
wherein a puncturing pattern is defined by a function defining the distance between parity bits to be punctured, the function having at least three different function values.

**6.** The method according to one of the preceding claims,
wherein a puncturing pattern is defined by a function defining the distance between parity bits to be punctured, the function having at least four different function values.

**7.** The method according to one of the preceding claims,
wherein
the turbo encoded signal is according to the stipulations of 3GPP TS 25.212 and
puncturing is performed to adjust at least one of the turbo coder's constituent code rates to $7n/(7n+1)$, n being any positive integer.

**8.** A method for puncturing a turbo encoded signal containing systematic bits, first parity bits and second parity bits, comprising
puncturing the first parity bits according to a first puncturing pattern,
puncturing the second parity bits according to a second puncturing pattern,
wherein the number of bits to be punctured in the first puncturing pattern is different from the number of bits to be punctured in the second puncturing pattern for an even total number of first and second parity bits to be punctured and/or the number of bits to be punctured in the first puncturing pattern is different from the number of bits to be punctured in the second puncturing pattern by 2 or more for an odd total number of first and second parity bits to be punctured.

**9.** The method according to claim 8, wherein
the total number of parity bits to be punctured is $\Delta N^{TTI}$,
the number of first parity bits to be punctured is $\text{floor}(\Delta N^{TTI}/2)+k$ or $\text{floor}(\Delta N^{TTI}/2)-k$, and
the number of second parity bits to be punctured is $\text{ceil}(\Delta N^{TTI}/2)-k$ or $\text{ceil}(\Delta N^{TTI}/2)+k$, respectively, wherein k is an integer different from zero.

**10.** The method according to claim 8, wherein
the total number of bits to be punctured is $N_{data}$, the number of transmitted systematic bits is $N_{t,sys}$, the number of first parity bits after rate matching is
$N_{t,p1} = \text{floor}((N_{data}-N_{t,sys})/2)-k$ or
$N_{t,p1} = \text{floor}((N_{data}-N_{t,sys})/2)+k$ and the number of second parity bits after rate matching is $N_{t,p2} = \text{ceil}((N_{data}-N_{t,sys})/2)+k$ or $N_{t,p2} = \text{ceil}((N_{data}-N_{t,sys})/2)-k$, respectively, wherein k is an integer different from zero.

**11.** The method according to claims 8 to 10,
wherein
the turbo encoded signal is according to the stipulations of 3GPP TS 25.212 and
puncturing is performed to adjust at least one of the turbo coder's constituent code rates to $7n/(7n+1)$, n being any positive integer.

**12.** A method for puncturing a convolutional encoded signal represented by a stream of encoded bits, comprising
puncturing the stream of encoded bits according to a puncturing pattern to adjust a desired code rate, wherein the puncturing pattern jitters.

**13.** The method according to claim 12, wherein a puncturing pattern is defined by a function defining the distance between encoded bits to be punctured, the function having at least two different function values being different to each other by more than 1.

**14.** The method according to claim 12, wherein a puncturing pattern is defined by a function defining the distance between encoded bits to be punctured, the function having at least three different function values.

**15.** The method according to claim 12, wherein a puncturing pattern is defined by a function defining the distance between encoded bits to be punctured, the function having at least four different function values.

**16.** An apparatus for puncturing a turbo encoded signal containing systematic bits and parity bits, the apparatus comprising
a puncturing device (20) puncturing the parity bits according to a puncturing pattern to adjust a desired code rate,

wherein the puncturing pattern jitters.

**17.** The apparatus according to claim 16, wherein
the turbo encoded signal comprises first and second parity bits,
the puncturing device (20) comprises first and second puncturing devices (22, 23), the first puncturing (22) device punctures first parity bits according to a first jittering puncturing pattern, and
the second puncturing device (23) punctures second parity bits according to a second jittering puncturing pattern.

**18.** The apparatus according to one of claims 16 or 17,
wherein
the first puncturing pattern and the second puncturing pattern are the same.

**19.** The apparatus according to one of claims 16 to 18,
wherein a puncturing pattern is defined by a function defining the distance between parity bits to be punctured, the function having at least two different function values being different to each other by more than 1.

**20.** The apparatus according to one of the claims 16 to 18,
wherein a puncturing pattern is defined by a function defining the distance between parity bits to be punctured, the function having at least three different function values.

**21.** The apparatus according to one of the claims 16 to 18,
wherein a puncturing pattern is defined by a function defining the distance between parity bits to be punctured, the function having at least four different function values.

**22.** The apparatus according to one of the claims 16 to 21,
wherein
the puncturing device (20) applies a puncturing pattern to adjust at least one of the turbo constituent code rates to $7n/(7n+1)$, n being any positive integer.

**23.** An apparatus for puncturing a turbo coded signal containing systematic bits, first parity bits and second parity bits,
a first puncturing device (22) puncturing the first parity bits according to a first puncturing pattern,
a second puncturing device (23) puncturing the second parity bits according to a second puncturing pattern,
wherein the number of bits to be punctured in the first puncturing pattern is different from the number of bits to be punctured in the second puncturing pattern for an even total number of first and second parity bits to be punctured and/or the number of bits to be punctured in the first puncturing pattern is different from the number of bits to be punctured in the second puncturing pattern by 2 or more for an odd total number of first and second parity bits to be punctured.

**24.** The apparatus according to claim 23, wherein
the total number of parity bits to be punctured is $\Delta N^{TTI}$,
the first puncturing device (11) punctures a number of floor $(\Delta N^{TTI}/2)$ +k or floor $(\Delta N^{TTI}/2)$ -k first parity bits,
the second puncturing device (12) punctures a number of ceil($\Delta N^{TTI}/2$)-k or ceil($\Delta N^{TTI}/2$)+k second parity bits, respectively, wherein k is an integer different from zero.

**25.** The apparatus according to claim 23, wherein
the total number of bits to be punctured is $N_{data}$, the number of transmitted systematic bits is $N_{t,sys}$, the number of first parity bits after rate matching is
$N_{t,p1}$ = floor $((N_{data}-N_{t,sys})/2)$-k or
$N_{t,p1}$ = floor $((N_{data}-N_{t,sys})/2)$+k and the number of second parity bits after rate matching is $N_{t,p2}$ = ceil($(N_{data}-N_{t,sys})/2$)+k or $N_{t,p2}$ = ceil($(N_{data}-N_{t,sys})/2$)-k, respectively, wherein k is an integer different from zero.

**26.** The apparatus according to claims 23 to 25,
wherein
the turbo encoded signal is according to the stipulations of 3GPP TS 25.212 and
the puncturing device (20) applies a puncturing pattern to adjust at least one of the turbo constituent code rates to approximately $7n/(7n+1)$, n being any positive integer.

**27.** An apparatus for puncturing a convolutional encoded signal represented by a stream of coded bits, the apparatus comprising a puncturing device (2) puncturing the coded bits according to a puncturing pattern to adjust a desired code rate, wherein the puncturing pattern jitters.

28. The apparatus according to claim 27, wherein a puncturing pattern is defined by a function defining the distance between coded bits to be punctured, the function having at least two different function values being different to each other by more than 1.

29. The apparatus according to claim 27, wherein a puncturing pattern is defined by a function defining the distance between coded bits to be punctured, the function having at least three different function values.

30. The apparatus according to claim 27, wherein a puncturing pattern is defined by a function defining the distance between coded bits to be punctured, the function having at least four different function values.

# FIG 1

# FIG 2

## FIG 3

## FIG 4

**EP 1 883 162 A1**

# EUROPEAN SEARCH REPORT

**European Patent Office**

| Application Number |
|---|
| EP 06 01 5514 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 2 399 723 A (* ROKE MANOR RESEARCH LIMITED; * SIEMENS AKTIENGESELLSCHAFT) 22 September 2004 (2004-09-22) * abstract * * page 7, line 1 - line 19 * * page 8, line 23 - page 9, line 22 * * page 10, line 27 - page 12, line 22 * * figures 3,5 * ----- | 1-7, 12-22, 27-30 | INV. H03M13/29 |
| X | SIEMENS: "Turbo Coder Irregularities in HSDPA" TDOC R1-03-0421 OF 3GPP TSG RAN WG 1, [Online] 23 May 2003 (2003-05-23), pages 1-5, XP002398817 Paris, France Retrieved from the Internet: URL:http://www.3gpp.org/ftp/tsg_ran/WG1_RL 1/TSGR1_32/Docs/Zips/> [retrieved on 2006-09-14] | 1-3,12, 16-18,27 | |
| A | * page 1 - page 5 *  * figure 4 * ----- -/-- | 4-7, 13-15, 19-22, 28-30 | TECHNICAL FIELDS SEARCHED (IPC) H03M H04L |

~~The present search report has been drawn up for all claims~~

| Place of search | Date of completion of the search | Examiner |
|---|---|---|
| Munich | 20 September 2006 | Burkert, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

**EUROPEAN SEARCH REPORT**

Application Number

EP 06 01 5514

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HIGHDIMENSION, ITRI: "Modifying puncturing pattern to improve performance and iterations of release 6 turbo coding" TDOC R1-06-1737 OF 3GPP TSG RAN WG 1, [Online] 30 June 2006 (2006-06-30), pages 1-4, XP002398818 Cannes. France Retrieved from the Internet: URL:http://www.3gpp.org/ftp/tsg_ran/WG1_RL 1/TSGR1_AH/LTE_AH_June-06/Docs/> [retrieved on 2006-09-14] | 1-3,12, 16-18,27 | |
| A | * page 1 - page 2 *  * figure 1 * | 4-7, 13-15, 19-22, 28-30 | |
| X | WO 01/39422 A (SIEMENS AKTIENGESELLSCHAFT; MICHEL, JUERGEN; RAAF, BERNHARD) 31 May 2001 (2001-05-31) * abstract * * page 3, line 4 - line 8 * * page 6, line 35 - page 7, line 13 * * figure 2A * | 12-15, 27-30 | TECHNICAL FIELDS SEARCHED (IPC) |

~~The present search report has been drawn up for all claims~~

| Place of search | Date of completion of the search | Examiner |
|---|---|---|
| Munich | 20 September 2006 | Burkert, Frank |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...........................................................................................
& : member of the same patent family, corresponding
    document

EPO FORM 1503 03.82 (P04C01)

European Patent

Office

Application Number

EP 06 01 5514

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-7, 12-22, 27-30

**European Patent Office**

**LACK OF UNITY OF INVENTION**
**SHEET B**

Application Number

EP 06 01 5514

The Search Division considers that the present European patent application does not comply with the requirements of unity of invention and relates to several inventions or groups of inventions, namely:

1. claims: 1-7, 12-22, 27-30

   These claims relate to puncturing of turbo or convolutionally encoded signals, wherein puncturing is performed according to a puncturing pattern that jitters.
   ---

2. claims: 8-11, 23-26

   These claims relate to puncturing of a turbo encoded signal comprising first and second parity bits, in which the number of bits punctured from the first parity bits is different from the number of bits punctured from the second parity bits.
   ---

## ANNEX TO THE EUROPEAN SEARCH REPORT
## ON EUROPEAN PATENT APPLICATION NO.

EP 06 01 5514

This annex lists the patent family members relating to the patent documents cited in the above-mentioned European search report.
The members are as contained in the European Patent Office EDP file on
The European Patent Office is in no way liable for these particulars which are merely given for the purpose of information.

20-09-2006

| Patent document cited in search report | | Publication date | Patent family member(s) | | Publication date |
|---|---|---|---|---|---|
| GB 2399723 | A | 22-09-2004 | NONE | | |
| WO 0139422 | A | 31-05-2001 | CN | 1399830 A | 26-02-2003 |
| | | | EP | 1232597 A2 | 21-08-2002 |
| | | | US | 7082565 B1 | 25-07-2006 |

For more details about this annex : see Official Journal of the European Patent Office, No. 12/82